# EUROPEAN PATENT APPLICATION

(11) **EP 4 847 926 A1**
(43) Date of publication of application: **02.12.2026**
(21) Application number: 25744875.3
(22) Date of filing: 10.01.2025
(51) Int. Cl.: G01R 27/02

(54) **PHYSICAL QUANTITY CALCULATION METHOD, PHYSICAL QUANTITY CALCULATION PROGRAM, AND PHYSICAL QUANTITY CALCULATION DEVICE**

(30) Priority: 22.01.2024 JP 2024007381
(71) Applicant: Panasonic Intellectual Property Management Co., Ltd., Kadoma-shi, Osaka 571-0057 (JP)
(72) Inventor: MAEDA, Suguru, kadoma-shi, Osaka 571-0057 (JP)
(74) Representative: Novagraaf International SA
(86) International application number: PCT/JP2025/000692
(87) International publication number: WO 2025/158943

(57) **Abstract**

A physical quantity calculation method includes: acquiring data representing an electronic state of a material calculated based on an arrangement of atoms constituting the material (S12); adjusting a parameter, in the data acquired, representing a Fermi level (S14); and calculating a physical quantity representing a physical property of the material based on the data acquired and an adjusted parameter representing the Fermi level (S18).

## Description

### TECHNICAL FIELD

The present disclosure relates to a physical quantity calculation method, a physical quantity calculation program, and a physical quantity calculation apparatus.

### BACKGROUND ART

Lithium transition metal oxides are used as electrode materials for batteries. Development of electrode materials with excellent property such as conductivity has been pursued to improve energy efficiency.

### RELATED-ART LITERATURE

### NON-PATENT LITERATURE

Non-patent literature 1: Georg K.H. Madsen et. al., Comput. Phys. Commun., 231, 140-145 (2018)
Non-patent literature 2: R. Amin et. al., J. Electrochem. Soc., 162 (7), 1163-1169 (2015)

### SUMMARY OF INVENTION

### TECHNICAL PROBLEM

The conductivity of the lithium transition metal oxide calculated by the method described in non-patent literature 1 deviates significantly from the experimental values described in non-patent literature 2, especially in a zone where the amount of lithium ions is small. Therefore, related-art methods cannot accurately predict the conductivity when the battery is discharged to produce lithium ion desorption. In order to develop novel electrode materials with excellent property, a technology to predict a physical quantity such as conductivity more accurately is necessary.

The present disclosure provides a technology to improve the accuracy of calculating a physical quantity.

### SOLUTION TO PROBLEM

A physical quantity calculation method in the present disclosure includes: acquiring data representing an electronic state of a material calculated based on an arrangement of atoms constituting the material; adjusting a parameter, in the data acquired, representing a Fermi level; and calculating a physical quantity representing a physical property of the material based on the data acquired and an adjusted parameter representing the Fermi level.

A physical quantity calculation apparatus in the present disclosure includes: an acquisition unit that acquires data representing an electronic state of a material calculated based on an arrangement of atoms constituting the material; an adjustment unit that adjusts a parameter, in the data acquired by the acquisition unit, representing a Fermi level; and a calculation unit that calculates a physical quantity representing a physical property of the material based on the data acquired by the acquisition unit and the parameter representing the Fermi level adjusted by the adjustment unit.

Optional combinations of the aforementioned constituting elements, and implementations of the present disclosure in the form of methods, apparatuses, systems, recording mediums, and computer programs may also be practiced as additional embodiments of the present invention.

### ADVANTAGEOUS EFFECTS OF INVENTION

According to the technology of the present disclosure, the accuracy of calculating a physical quantity can be improved.

### BRIEF DESCRIPTION OF DRAWINGS

[Fig. 1] Fig. 1 is a flowchart showing steps of a physical quantity calculation method of embodiment 1.
[Fig. 2] Fig. 2 shows an example of the atomic arrangement of a lithium transition metal oxide.
[Fig. 3] Fig. 3 shows an example of the band structure of a lithium transition metal oxide.
[Fig. 4] Fig. 4 shows an example of the conductivity of a lithium transition metal oxide.
[Fig. 5] Fig. 5 shows a configuration of the physical quantity calculation apparatus of embodiment 1.

### DESCRIPTION OF EMBODIMENTS

An embodiment will be described with reference to the drawings. However, descriptions more detailed than necessary may be omitted. For example, a detailed description of well-known matter or a duplicate description of substantially identical features may be omitted.

The attached drawings and the description below are provided to help skilled persons to understand the present disclosure fully and are not intended to limit the subject matter defined by the claims.

### (Embodiment 1)

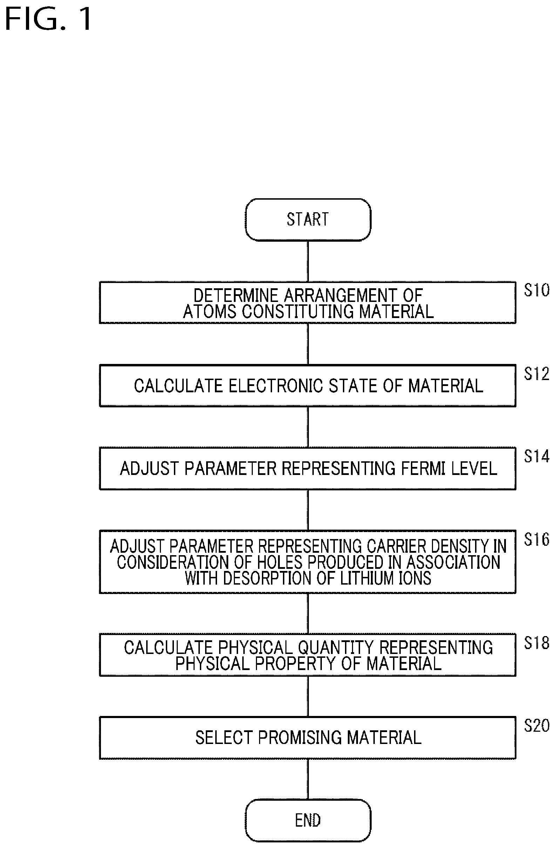

Embodiment 1 will now be described with reference to Figs. 1-5.

Fig. 1 is a flowchart showing steps of a physical quantity calculation method of embodiment 1. The physical quantity calculation method of embodiment 1 is performed by a physical quantity calculation apparatus realized by, for example, a program implemented in a computer. In embodiment 1, a description is given of a case of calculating the conductivity of a lithium transition metal oxide used as the positive electrode in a lithium-ion battery as an example of physical quantity.

### [Step S10: Determination of atomic arrangement]

In step S10, the physical quantity calculation apparatus determines the arrangement of atoms constituting the material of interest. Specifically, the physical quantity calculation apparatus creates a structural file of the lithium transition metal oxide. The structural file may be acquired from a crystal structure database. The structural file may be created by using crystal structure drawing software based on information described in a literature such as an academic paper. The structural file may be created with reference to the atomic arrangement of a material with a known atomic arrangement and similar constituent atoms. The structural file may be created by any other method.

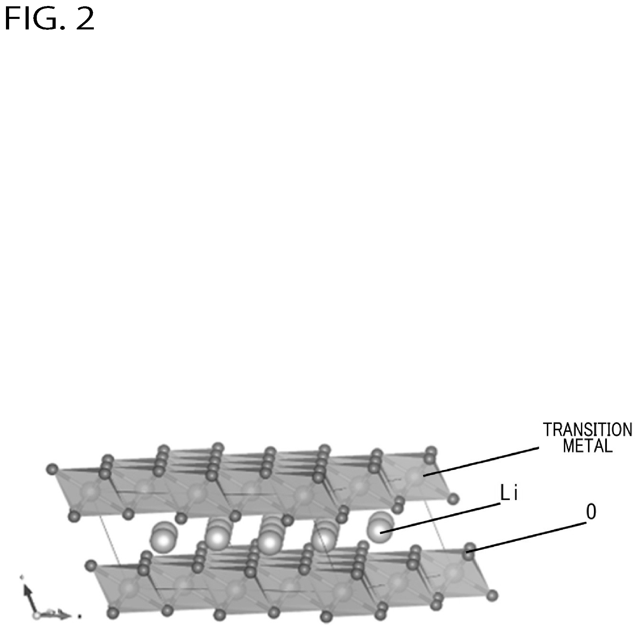

Fig. 2 shows an example of the atomic arrangement of a lithium transition metal oxide. A lithium transition metal oxide such as LiCoO₂ and LiNiO₂ have, as shown in Fig. 2, a bedded rock salt structure (α-NaFeO₂ type) in which a transition metal and lithium are regularly arranged in the direction of <111> of the cubic rock salt structure to form a two-dimensional plane. A lithium transition metal oxide with transition metal sites replaced by other transition metal elements may also be determined to have a similar atomic arrangement, and a structural file thereof may be created.

[Step S12: Calculation of electronic state] In step S12, the physical quantity calculation apparatus calculates the electronic state of the material. The electronic state of the material may be calculated by known first-principles calculation software that performs first-principles band calculations according to any calculation technique. First-principles calculation software receives inputs of the initial atomic arrangement represented by the structural file, the potential of each atom, and the calculation conditions and calculates the stable atomic arrangement, electronic structure, energy, etc. based on density functional theory (DFT), etc. First-principles calculation software calculates the force applied to each atom by calculating the electronic state based on the initial atomic arrangement and then moves each atom by an amount commensurate with the calculated force to obtain a more stable atomic arrangement. This process is repeated, and the atomic arrangement that occurs when the force exerted on each atom is below the reference value is considered to be a stable atomic arrangement, and the electronic structure, energy, etc. at that time are output.

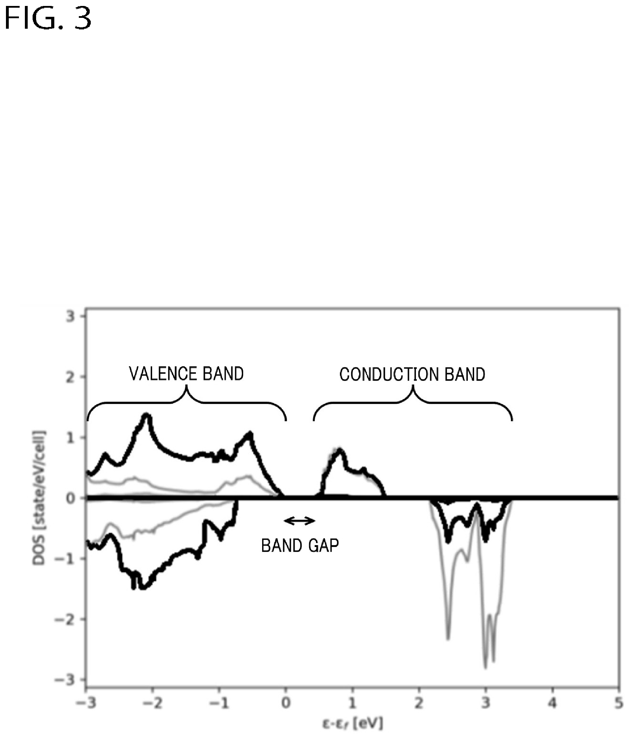

Fig. 3 shows an example of the band structure of a lithium transition metal oxide. In Fig. 3, the state density of the transition metal calculated in consideration of the electron spin is denoted by a dark solid line, and the state density of oxygen is denoted by a thin solid line. A lithium transition metal oxide is a semiconductor, and the Fermi level is located in the bandgap between the electron-filled valence band and the empty conduction band.

### [Step S14: Adjustment of Fermi level]

In step S14, the parameter representing the Fermi level is adjusted.

The Fermi level Ei of an intrinsic semiconductor is given by the following expression by using the energy EC at the lower end of the conduction band, the energy EV at the upper end of the valence band, and the effective state densities NC and NV. ${E}_{i} = \frac{{E}_{C} + {E}_{V}}{2} + \frac{1}{2} kT ln \frac{{N}_{V}}{{N}_{C}}$ Since the second term is sufficiently small, the Fermi level Ei is located approximately in the middle of the bandgap.

The Fermi level EF of a semiconductor doped with impurities is given by the following expression by using the intrinsic carrier density ni, the electron density n in the conduction band, and the hole density p in the valence band. ${E}_{F} = {E}_{i} + kT ln \frac{n}{{n}_{i}} = {E}_{i} - kT ln \frac{p}{{n}_{i}}$ The larger the doping amount of impurities, the closer the position of the Fermi level is to the band end. In other words, the higher the electron density n of the conduction band, the closer the position of the Fermi level is to the lower end of the conduction band, and the higher the hole density p of the valence band, the closer the position of the Fermi level is to the upper end of the valence band.

Therefore, the Fermi level of the lithium transition metal oxide can vary depending on the material's state density, energy, electron spin, valence, bond distance, local strain, point defects, composition, etc.

Further, when the lithium transition metal oxide is used as the positive electrode in a lithium-ion battery, lithium ions enter and leave in association with charging and discharging so that the hole density p of the valence band changes, and the position of the Fermi level fluctuates. The position of the Fermi level can also change depending on the material such as the electrolyte and the negative electrode that are in electrical contact with the positive electrode.

In this way, when calculating the conductivity of the electrode material in primary and secondary batteries where carrier ions could be defective, such as the lithium transition metal oxide in a lithium-ion battery, it is not sufficient to set, as in the related art, an appropriate Fermi level value by considering the Fermi-Dirac distribution at the temperature at which the battery is used. As described above, the calculated value deviates greatly from the experimental value particularly in a zone where the amount of carrier ions is small.

To solve these problems, the physical quantity calculation method of embodiment 1 involves adjusting the parameter representing the Fermi level based on at least one of the state density, energy, electron spin, valence, bond distance, local strain, point defects, or composition of the material in question and of the material in contact with it. This enables more accurate calculation of the conductivity of the material. It also enables more accurate prediction of changes in the conductivity associated with the desorption and insertion of carrier ions.

The physical quantity calculation apparatus may adjust the parameter so that the Fermi level is closer to the valence band than to the middle of the bandgap. The physical quantity calculation apparatus may adjust the parameter so that the Fermi level is at the position of 0%, 5%, 10%, 15%, 20%, 25%, 30%, 35%, 40%, 45%, and 50% of the bandgap from the upper end of the valence band. The physical quantity calculation apparatus may adjust the parameter so that the higher the hole density, local strain or the larger the number of point defects in the material, the closer the Fermi level is to the upper end of the valence band. The physical quantity calculation apparatus may adjust the parameter so that the larger the amount of lithium ion desorption, the closer the Fermi level is to the upper end of the valence band.

### [Step S16: Adjustment of carrier density]

In step S16, the physical quantity calculation apparatus adjusts the parameter representing the carrier density in consideration of holes produced in association with the desorption of lithium ions. This enables more accurate prediction of changes in the conductivity associated with charging and discharging of the lithium-ion battery in which the lithium transition metal oxide is as the positive electrode.

### [Step S18: Calculation of conductivity]

In step S18, the physical quantity calculation apparatus calculates the conductivity of the lithium transition metal oxide based on the data calculated in step S12, the parameter representing the Fermi level adjusted in step S14, and the parameter representing the carrier density adjusted in step S16. The physical quantity calculation apparatus may calculate the conductivity by any known method.

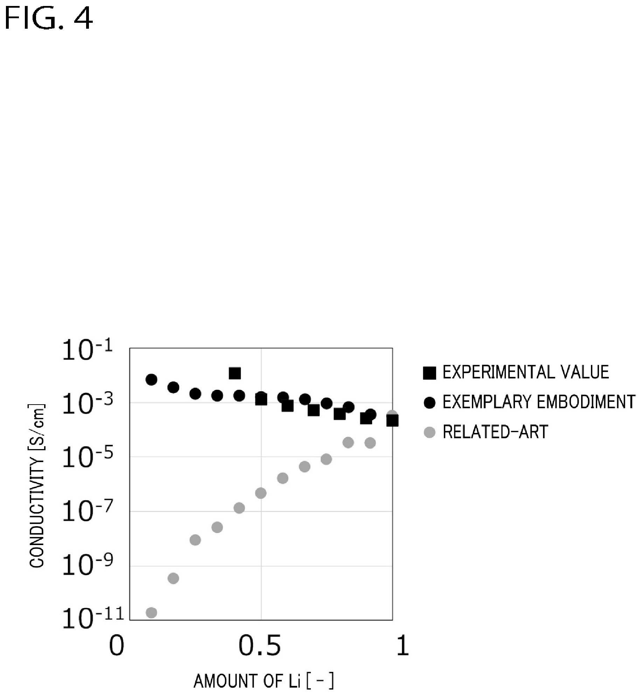

Fig. 4 shows an example of the conductivity of a lithium transition metal oxide. In Fig. 4, black squares denote experimental values, black circles represent values calculated by the physical quantity calculation method of embodiment 1, and gray circles denote values calculated by the related-art method. The related-art method does not consider the impact of Fermi level and carrier density associated with lithium ion desorption, and so the smaller the amount of lithium ions, the more deviated the calculated value is from the experimental value. The value calculated by the physical quantity calculation method of embodiment 1 is approximately equal to the experimental value. It is demonstrated that the physical quantity calculation method of embodiment 1 can calculate the conductivity more accurately even in the presence of carrier ion desorption.

### [Step S20: Selection of promising material]

In step S20, a promising material is selected as a material of the electrode based on the conductivity calculated in S18. For example, a material exhibiting high conductivity over a large zone even if the amount of lithium ions changes due to lithium ion desorption or insertion can be selected as a promising material. This enables efficient selection of a novel material having an excellent property and so can reduce the time, effort, and cost required to design a battery.

### [Configuration of physical quantity calculation apparatus]

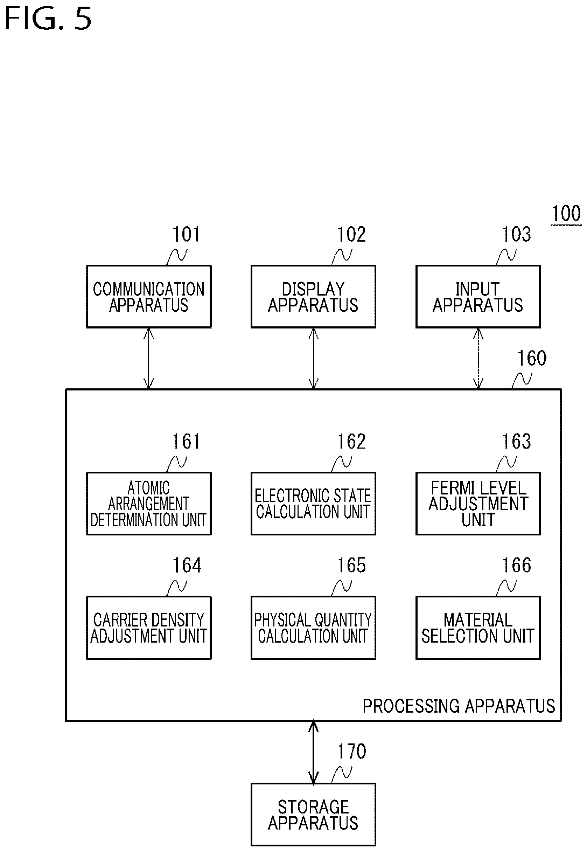

Fig. 5 shows a configuration of the physical quantity calculation apparatus 100 of embodiment 1. The physical quantity calculation apparatus 100 is equipped with a communication apparatus 101, a display apparatus 102, an input apparatus 103, a processing apparatus 160, and a storage apparatus 170. The physical quantity calculation apparatus 100 may be any computer such as a personal computer and a server apparatus.

The communication apparatus 101 controls communication with other apparatuses over a communication network. The communication apparatus 101 may communicate by any wired or wireless communication scheme. The display apparatus 102 displays a screen generated by the processing apparatus 160. The display apparatus 102 may be a liquid crystal display apparatus, an organic EL display apparatus, etc. The input apparatus 103 transmits an instruction input by the user of the physical quantity calculation apparatus 100 to the processing apparatus 160. The input apparatus 103 may be a mouse, keyboard, touchpad, etc. The display apparatus 102 and the input apparatus 103 may be implemented by a touch panel.

The storage unit 170 stores a program, data, etc. used by the processing apparatus 160. The storage apparatus 170 may be a semiconductor memory, a hard disk, etc.

The processing apparatus 160 is equipped with an atomic arrangement determination unit 161, an electronic state calculation unit 162, a Fermi level adjustment unit 163, a carrier density adjustment unit 164, a physical quantity calculation unit 165, and a material selection unit 166. These features are implemented by hardware such as a circuit, a CPU and a memory of a computer, other LSIs, etc. These features are implemented by software such as a program loaded into a memory. In this case, the functional blocks realized by their cooperation are depicted. Therefore, it will be understood by those skilled in the art that these functional blocks may be implemented in a variety of manners such as hardware only or a combination of hardware and software.

The atomic arrangement determination unit 161 determines the arrangement of atoms constituting the material of interest in step S10 of the physical quantity calculation method of embodiment 1.

The electronic state calculation unit 162 calculates the electronic state of the material based on the atomic arrangement determined by the atomic arrangement determination unit 161 in step S12 of the physical quantity calculation method of embodiment 1.

The Fermi level adjustment unit 163 adjusts the parameter, in the data calculated by the electronic state calculation unit 162 in step S14 of the physical quantity calculation method of embodiment 1, representing the Fermi level.

The carrier density adjustment unit 164 adjusts the parameter, in the data calculated by the electronic state calculation unit 162 in step S16 of the physical quantity calculation method of embodiment 1, representing the carrier density in consideration of carriers produced in association with the desorption of atoms and ions.

The physical quantity calculation unit 165 calculates, in step S18 of the physical quantity calculation method of embodiment 1, the physical quantity of the material based on the data calculated by the electronic state calculation unit 162, the parameter representing the Fermi level adjusted by the Fermi level adjustment unit 163, and the parameter representing the carrier density adjusted by the carrier density adjustment unit 164.

The material selection unit 166 selects a material with excellent property based on the physical quantity calculated by the physical quantity calculation unit 165.

### [Advantage]

As described above, the physical quantity calculation method includes, in the embodiment, the step (S12) to acquire the data representing the electronic state of the material calculated based on the arrangement of atoms constituting the material, the step (S14) to adjust the parameter, in the acquired data, representing the Fermi level, and the step (S18) to calculate the physical quantity representing the physical property of the material based on the acquired data and the adjusted parameter representing the Fermi level. This enables more accurate calculation of the physical quantity of the material. It also enables more accurate prediction of changes in the physical quantity associated with the desorption and insertion of atoms and ions.

In the embodiment, the step (S18) to adjust the parameter representing the Fermi level includes the step to adjust the parameter representing the Fermi level based on at least one of the state density, energy, electron spin, valence, bond distance, local strain, point defects, or composition of the material and of the material in contact with it. This enables more accurate calculation of the physical quantity of the material. It also enables more accurate prediction of changes in the physical quantity associated with the desorption and insertion of atoms and ions.

In the embodiment, the material is the material used for the electrode of the lithium-ion battery, and the physical quantity calculation method further includes the step (S16) to adjust the parameter, in the acquired data, representing the carrier density in consideration of holes produced in the material in association with the desorption of lithium ions, and the step (S18) to calculate the physical quantity includes the step to calculate the physical quantity representing the physical property of the material based further on the adjusted parameter representing the adjusted carrier density. This enables more accurate calculation of the physical quantity of the material. It also enables more accurate prediction of changes in the physical quantity associated with the desorption and insertion of lithium ions.

In further accordance with the embodiment, the steps (S12) to acquire data include the step (S10) to determine the arrangement of atoms constituting the material, and the step (S12) to calculate the electronic state of the material based on the arrangement of atoms determined. This enables more accurate calculation of the physical quantity of the material. It also enables more accurate prediction of changes in the physical quantity associated with the desorption and insertion of atoms and ions.

In further accordance with the embodiment, the physical quantity is conductivity. This enables more accurate calculation of the physical quantity of the material. It also enables more accurate prediction of changes in the physical quantity associated with the desorption and insertion of atoms and ions.

In further accordance with the embodiment, the physical quantity calculation program includes modules including: a module (S12) that acquires data representing an electronic state of a material calculated based on an arrangement of atoms constituting the material; a module (S14) that adjusts a parameter, in the data acquired, representing a Fermi level; and a module (S18) that calculates a physical quantity representing a physical property of the material based on the data acquired and an adjusted parameter representing the Fermi level. This enables more accurate calculation of the physical quantity of the material. It also enables more accurate prediction of changes in the physical quantity associated with the desorption and insertion of atoms and ions.

In further accordance with the embodiment, the physical quantity calculation apparatus 100 comprises the electronic state calculation unit 162 that acquires the data representing the electronic state of the material calculated based on the arrangement of atoms constituting the material, the Fermi level adjustment unit 163 that adjusts the parameter, in the data calculated by the electronic state calculation unit 162, representing the Fermi level, and the physical quantity calculation unit 165 that calculates the physical quantity representing the physical property of the material based on the data calculated by the electronic state calculation unit 162 and the parameter representing the Fermi level adjusted by the Fermi level adjustment unit 163. This enables more accurate calculation of the physical quantity of the material. It also enables more accurate prediction of changes in the physical quantity associated with the desorption and insertion of atoms and ions.

### (Other embodiments)

As described above, embodiment 1 has been described as an example of the technology disclosed in this application. However, the technology in this disclosure is not limited to this but can also be applied to embodiments produced by modification, replacement, addition, omission, etc. It is also possible to combine components described in embodiment 1 above to produce a new embodiment.

An exemplary alternative embodiment will be described.

Although the case of calculating the conductivity of the lithium transition metal oxide was mainly described in embodiment 1, the technology disclosed herein is broadly applicable to the calculation of physical quantities representing the electrical, magnetic, and mechanical properties of materials such as semiconductors and insulators. In the case atoms and ions contained in the material undergo desorption, in particular, it is possible to predict changes in the physical quantity associated with the desorption of atoms and ions accurately.

The embodiment described above represents an illustration of the technology in this disclosure, and so modification, replacement, addition, omission, etc. can be made in a variety of manners within the scope of the claims or the equivalents thereof.

### (Additional note)

The following technologies are disclosed according to the above description of the embodiment.

### (Technology 1)

A physical quantity calculation method including:
acquiring data representing an electronic state of a material calculated based on an arrangement of atoms constituting the material;
adjusting a parameter, in the data acquired, representing a Fermi level; and
calculating a physical quantity representing a physical property of the material based on the data acquired and an adjusted parameter representing the Fermi level.

This enables more accurate calculation of the physical quantity of the material. It also enables more accurate prediction of changes in the physical quantity associated with the desorption and insertion of atoms and ions.

### (Technology 2)

The physical quantity calculation method according to Technology 1,
wherein the adjusting of a parameter representing a Fermi level includes adjusting the parameter representing the Fermi level based on at least one of a state density, energy, electron spin, valence, bond distance, local strain, point defects, or composition of the material and of a material in contact with the material.

This enables more accurate calculation of the physical quantity of the material. It also enables more accurate prediction of changes in the physical quantity associated with the desorption and insertion of atoms and ions.

### (Technology 3)

The physical quantity calculation method according to Technology 1 or 2,
wherein the material is a material used in an electrode of a lithium-ion battery,
wherein the method further includes adjusting a parameter representing a carrier density in consideration of holes produced in the material in association with desorption of lithium ions, and
wherein the calculating of a physical quantity includes calculating a physical quantity representing a physical property of the material based further on an adjusted parameter representing a carrier density.

This enables more accurate calculation of the physical quantity of the material. It also enables more accurate prediction of changes in the physical quantity associated with the desorption and insertion of atoms and ions.

### (Technology 4)

The physical quantity calculation method according to any one of Technologies 1 through 3,
wherein the acquiring of data includes:
determining an arrangement of atoms constituting the material; and
calculating the electronic state of the material based on the arrangement of atoms determined.

This enables more accurate calculation of the physical quantity of the material. It also enables more accurate prediction of changes in the physical quantity associated with the desorption and insertion of atoms and ions.

### (Technology 5)

The physical quantity calculation method according to any one of Technologies 1 through 4,
wherein the physical quantity is conductivity.

This enables more accurate calculation of the physical quantity of the material. It also enables more accurate prediction of changes in the physical quantity associated with the desorption and insertion of atoms and ions.

### (Technology 6)

A physical quantity calculation program including computer-implemented modules including:
a module that acquires data representing an electronic state of a material calculated based on an arrangement of atoms constituting the material;
a module that adjusts a parameter, in the data acquired, representing a Fermi level; and
a module that calculates a physical quantity representing a physical property of the material based on the data acquired and an adjusted parameter representing the Fermi level.

This enables more accurate calculation of the physical quantity of the material. It also enables more accurate prediction of changes in the physical quantity associated with the desorption and insertion of atoms and ions.

### (Technology 7)

A physical quantity calculation apparatus including: an acquisition unit that acquires data representing an electronic state of a material calculated based on an arrangement of atoms constituting the material;
an adjustment unit that adjusts a parameter, in the data acquired by the acquisition unit, representing a Fermi level; and
a calculation unit that calculates a physical quantity representing a physical property of the material based on the data acquired by the acquisition unit and the parameter representing the Fermi level adjusted by the adjustment unit.

This enables more accurate calculation of the physical quantity of the material. It also enables more accurate prediction of changes in the physical quantity associated with the desorption and insertion of atoms and ions.

### INDUSTRIAL APPLICABILITY

The present disclosure is applicable as a physical quantity calculation apparatus to calculate the physical quantity of a material that can be used as an electrode, etc.

### REFERENCE SIGNS LIST

- 100: physical quantity calculation apparatus
- 101: communication apparatus
- 102: display apparatus
- 103: input apparatus
- 160: processing apparatus
- 161: atomic arrangement determination unit
- 162: electronic state calculation unit
- 163: Fermi level adjustment unit
- 164: carrier density adjustment unit
- 165: physical quantity calculation unit
- 166: material selection unit
- 170: storage apparatus

## Claims

1. A physical quantity calculation method comprising:
acquiring data representing an electronic state of a material calculated based on an arrangement of atoms constituting the material;
adjusting a parameter, in the data acquired, representing a Fermi level; and
calculating a physical quantity representing a physical property of the material based on the data acquired and an adjusted parameter representing the Fermi level.

2. The physical quantity calculation method according to claim 1,
wherein the adjusting of a parameter representing a Fermi level includes adjusting the parameter representing the Fermi level based on at least one of a state density, energy, electron spin, valence, bond distance, local strain, point defects, or composition of the material and of a material in contact with the material.

3. The physical quantity calculation method according to claim 1 or 2,
wherein the material is a material used in an electrode of a lithium-ion battery,
wherein the method further comprises adjusting a parameter representing a carrier density in consideration of holes produced in the material in association with desorption of lithium ions, and
wherein the calculating of a physical quantity includes calculating a physical quantity representing a physical property of the material based further on an adjusted parameter representing a carrier density.

4. The physical quantity calculation method according to claim 1 or 2,
wherein the acquiring of data includes:
determining an arrangement of atoms constituting the material; and
calculating the electronic state of the material based on the arrangement of atoms determined.

5. The physical quantity calculation method according to claim 1 or 2,
wherein the physical quantity is conductivity.

6. A physical quantity calculation program comprising computer-implemented modules including:
a module that acquires data representing an electronic state of a material calculated based on an arrangement of atoms constituting the material;
a module that adjusts a parameter, in the data acquired, representing a Fermi level; and
a module that calculates a physical quantity representing a physical property of the material based on the data acquired and an adjusted parameter representing the Fermi level.

7. A physical quantity calculation apparatus comprising:
an acquisition unit that acquires data representing an electronic state of a material calculated based on an arrangement of atoms constituting the material;
an adjustment unit that adjusts a parameter, in the data acquired by the acquisition unit, representing a Fermi level; and
a calculation unit that calculates a physical quantity representing a physical property of the material based on the data acquired by the acquisition unit and the parameter representing the Fermi level adjusted by the adjustment unit.
